# EUROPEAN PATENT SPECIFICATION

(11) **EP 2 933 886 B1**
(45) Date of publication and mention of the grant of the patent: **28.08.2019**
(21) Application number: 14165022.6
(22) Date of filing: 16.04.2014
(51) Int. Cl.: H01S 5/14, H01S 5/40, H01S 3/08

(54) **Laser beam generating device and method for adjusting a wavelength of a laser beam**
Laserstrahlerzeugungsvorrichtung und Verfahren zur Einstellung einer Wellenlänge eines Laserstrahles
Dispositif de génération de faisceau laser et procédé de réglage d'une longueur d'onde d'un faisceau laser

(43) Date of publication of application: 21.10.2015
(73) Proprietor: DirectPhotonics Industries GmbH, 12489 Berlin (DE)
(72) Inventor: Ferrario, Fabio, 10247 Berlin (DE); Kruschke, Bastian, 13405 Berlin (DE); Fritsche, Haro, 10781 Berlin (DE); Koch, Ralf, 18144 Lindingö (SE)
(74) Representative: Gulde & Partner

(56) References cited:
- EP-A1- 1 850 431
- EP-A2- 1 349 245
- US-B1- 6 876 679

## Description

The current invention concerns a laser beam generating device and a method for adjusting a wavelength of a laser beam.

Laser beam generation commonly involves a laser source element and a cavity. The cavity serves as a resonator for forming standing light waves. The cavity may be formed by additional elements then being called external cavity. A laser source element for such an external cavity may be a laser diode.

An external cavity is advantageous in allowing for arrangement of a wavelength selective element within the cavity thereby achieving a wavelength dependent feedback. The laser source element may such be locked to a specific frequency. Examples of wavelength selective element comprise gratings, e.g. volume Bragg gratings (VBG), and Fabry-Perot-Interferometer (Etalon) as well as combinations thereof.

In a Littrow configuration a diode having a back facet generates a beam which is collimated and then interacts with a diffraction grating. The grating is configured to reflect the 1^{st} diffraction mode back while the 0^{th} diffraction mode forms the output beam. The back facet constitutes the resonator together with the diffraction grating. Adjusting the grating allows for adjusting the laser's wavelength but causes the output beam to pan.

In a Littman configuration the 1^{st} mode is not directly reflected back by the grating but reflected onto a mirror. The mirror then reflects the 1st mode back into the diode. Adjusting the mirror allow for adjusting the laser's wavelength whilst panning of the output beam is avoided.

Daneu V., et al., describe in Opt. Lett., 2000 Mar 15; 25(6):405-7, a "spectral beam combining of a broad-stripe diode laser array in an external cavity". The outputs from an 11-element, linear diode laser array with broad stripes have been beam combined into a single beam using a common external cavity containing a grating, which simultaneously forces each array element to operate at a different, but controlled, wavelength and forces the beams from all the elements to overlap and propagate in the same direction. Such combination is also called wavelength multiplexing.

WO2013143862 describes a laser diode with an external volume Bragg grating that can be used for pumping, wherein a coupled resonator of the LD has a Yb:YAG as a laser-active medium, as well as a Fabry-Perot etalon for suppressing spectral components that are not suppressed by the narrow-band VBG. US 6,876,679 B1 describes multiplexing of incoherent laser beams by means of filters and a Bragg grating. EP 1 850 431 A1 teaches changing the inclination of an etalon with respect to incident light for changing wavelength of etalon peaks. EP 1 349 245 A2 describes a wavelength-selectable laser capable of high-speed frequency control.

The current invention addresses the objective of further improving laser beam generation and wavelength adjustment. The current invention particularly allows for simplifying the combination of laser source elements such that they operate at different, but controlled, wavelengths with their beams overlapping and propagating in the same direction. Hence the current invention allows for stabilizing the wavelength alone as well as for multiplexing and stabilizing in a single embodiment.

This is achieved by the laser beam generating device of claim 1. Advantageous embodiments are specified in the dependent claims.

The laser beam generating device comprises at least one laser source element and an external cavity. The external cavity comprises an output coupler and a periodic filter element arranged, on a light path from the laser source element and the output coupler, between the laser source and the output coupler. The laser beam generating device is characterized in that the laser beam generating device further comprises at least two cut-off filter elements each arranged on the light path between the laser source element and the periodic filter element, wherein a first cut-off filter element comprises a first cut-off wavelength and a second cut-off element comprises a second cut-off wavelength, and wherein the at least two cut-off filter elements realize a band pass filter element having a pass band between the at least first and second cut-off wavelengths and selecting one or more periodic peaks from the periodic filter element and wherein the periodic filter element is realized by an etalon.

Through the use of cut-off filter elements, a band pass filter element is realized in a simple manner which additionally allows for spectral combination of the laser source elements. Through the band pass a single resonance mode of the periodic filter element is fed back into the laser source element. So the laser source element is locked to emission at a peak frequency of the single resonance mode.

In an embodiment, the external cavity may be optimized using a set of optical elements located in the external cavity and choice of the output coupler reflectivity and curvature.

The cut-off filter elements may be long pass-filter elements having different cut-off wavelengths of which each allows radiation of wavelengths longer than a respective cut-off wavelength to pass, and at least reflect radiation of wavelengths shorter than the respective cut-off wavelength. For instance, the at least two long pass filter elements may be cold mirrors. The cold mirrors may comprise dielectric coating layers.

Or, the cut-off filter elements are short pass-filter elements of which each allows radiation of wavelengths shorter than a respective cut-off wavelength to pass, and at least reflect radiation of wavelengths longer than the respective cut-off wavelength. Or, one of the cut-off filter elements is a long pass-filter element and one is a short pass filter element.

The laser source element and the at least two cut-off filter elements may be arranged on the light path such that light of the laser source element is irradiated onto a first of the at least two cut-off filter elements and a reflected part of the irradiated light is reflected by the first cut-off filter element onto a second of the at least two cut-off filter elements through which it is transmitted.

A further laser source element may be comprised by the laser beam generating device said further laser source element being arranged on the light path such that further light of the further laser source element is irradiated onto the second cut-off filter element and reflected by the second cut-off filter element such that it is kept in the cavity.

Then, a further cut-off filter element may be comprised by the laser beam generating device, the further cut-off filter element being arranged, either, on a further light path between the second cut-off filter element and the further laser source element, or, on the light path between the second cut-off filter element and the periodic filter element.

The laser source element and/or the further laser source element may be laser diodes emitting light which diverges in a first direction faster than in a second direction perpendicular to the first direction, the laser diodes and dichroic mirrors being arranged such that light of the laser diodes is superposed in the first direction.

Then, collimating devices may be comprised by laser beam generating device the collimating devices collimating the light emitted by the laser diodes, the collimating devices collimating in the first direction and in the second direction. The laser diodes may be single emitters. Single emitters may be arranged in an array. Single emitters may be stacked horizontally or vertically.

The periodic filter element may comprise two parallel plates placed spaced apart with air in between wherein sides of the plates facing each other. The plates can be coated to tailor the power reflectivity.

It is further proposed a method according to claim 12 for adjusting a wavelength of a laser beam using the laser beam generating device according to the invention. The method comprises fine adjusting the wavelength by turning the etalon around an axis for varying an incident angle.

The different embodiments of this invention can be combined advantageously with each other.

Below, exemplary embodiments of the invention will be described in more detail by help of the figures wherein
- Figure 1: shows a first exemplary embodiment of the laser beam generating device according to the invention;
- Figure 2: schematically shows transmission T in dependency on wavelength lambda of the cut-off filter elements and the periodic filter element of the exemplary embodiment of figure 1;
- Figure 3: shows a second exemplary embodiment of the laser beam generating device according to the invention;
- Figure 4: shows a third exemplary embodiment of the laser beam generating device according to the invention;
- Figure 5: shows a fourth exemplary embodiment of the laser beam generating device according to the invention;
- Figure 6: shows a fifth exemplary embodiment of the laser beam generating device according to the invention;
- Figure 7: schematically shows transmission T in dependency on wavelength lambda of the cut-off filter elements and the periodic filter element of the exemplary embodiment of figure 6; and
- Figure 8: shows a sixth exemplary embodiment of the laser beam generating device according to the invention.

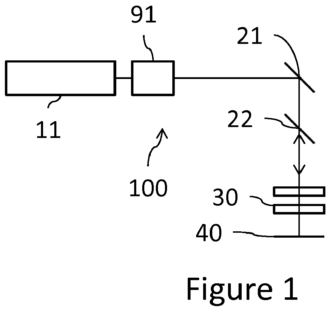

Figure 1 shows a first exemplary embodiment of the laser beam generating device according to the invention.

The first embodiment comprises a laser source element exemplarily realized by a laser diode 11 and at least two cut-off filter elements exemplarily realized by long pass filter elements 21, 22. The long pass filter elements 21, 22 are arranged such that a portion of the light emitted by the laser diode 11 is reflected by a first of the at least two long pass filter elements 21, 22. The reflected portion comprises wavelengths shorter than a first cut-off wavelength W1. The reflected portion is reflected onto a second of the at least two long pass filter elements 21, 22. Of said portion reflected on the second long pass filter element 22, the second long pass filter element 22 lets pass a transmitted portion onto a periodic filter element exemplarily realized by an etalon 30. The portion let pass comprises wavelengths equal to or longer than a second cut-off wavelength W2 said second cut-off wavelength W2 being shorter than the first cut-off wavelength W1. Light passing through the etalon 30 meets an output coupler 40, also called output mirror, where it is reflected back through the etalon 30 onto the second long pass filter element 22. The back-reflected light is than filtered through the etalon and filters and fed back into the laser source, selecting in this way the emitted wavelength.

In the depicted first exemplary embodiment, there is an optical element 91 located in the external cavity for optimizing performance. But the optical element 91 is optional and this exemplary embodiment of the invention may be realized without, also.

Thus, while the etalon 30 allows for a precise selection of wavelengths, the at least two long pass filter elements 21, 22 realize a band pass filter element having a pass band between the first and the second cut-off wavelengths W1, W2 and selecting one or more of the periodic peaks achievable by the etalon 30.

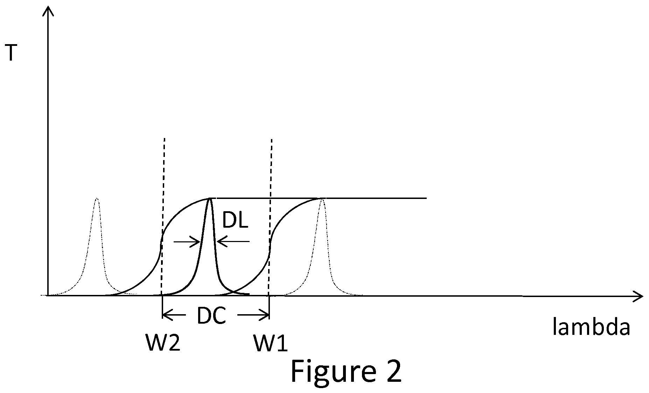

Figure 2 schematically shows transmission T in dependency on wavelength lambda of the cut-off filter elements and the periodic filter element of the exemplary embodiment of figure 1. As exemplarily depicted in figure 2, the peak has a peak width DL of the selected mode of the periodic filter element which is about half as wide as the width DC=W1-W2 of the pass band between the first and the second cut-off wavelengths W1, W2. Modes are shown in dotted lines which are suppressed in the feedback by the cut-off filter elements.

This provides a very precise wavelength locking. In addition thereto, light of a second laser source element can be superposed and thus spectrally combined easily.

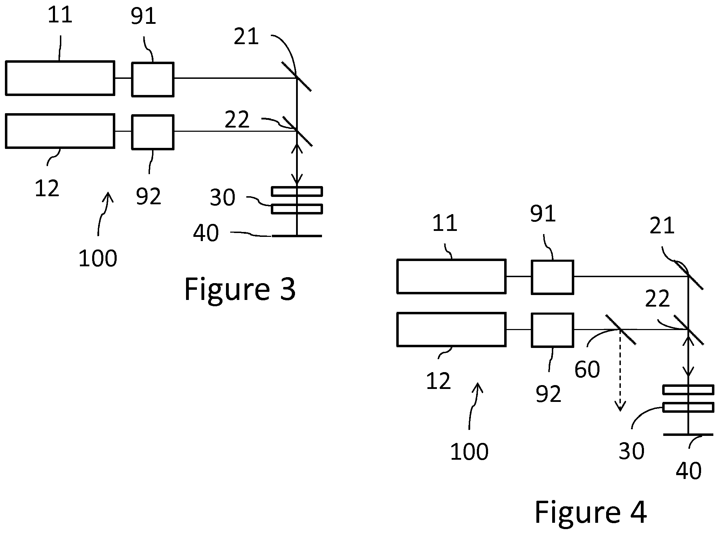

Superposition can be achieved, for instance, by emitting further light of a second laser source element 12 onto the second long pass filter element 22 such that the second long pass filter element 22 reflects onto the etalon 30 a further reflected portion of the further light. This is shown exemplarily in figure 3 depicting a second exemplary embodiment of the laser beam generating device according to the invention.

Then, the light of the first laser diode 11 reaching the etalon does not have common wavelengths with the further light of the second laser diode 12 reaching the etalon. And, of the light reflected back by the output coupler 40 and passed back through the etalon 30 the second long pass filter element 22 reflects back into the laser diode light of wavelengths shorter than the second cut-off wavelength W2. Of said back reflected and passed back through light, the first long pass filter element 21 reflects back into the laser diode light of wavelengths equal to or greater than second cut-off wavelength W2 but shorter than the first cut-off wavelength W1 thereby selecting one or more of the periodic peaks achievable by the etalon 30.

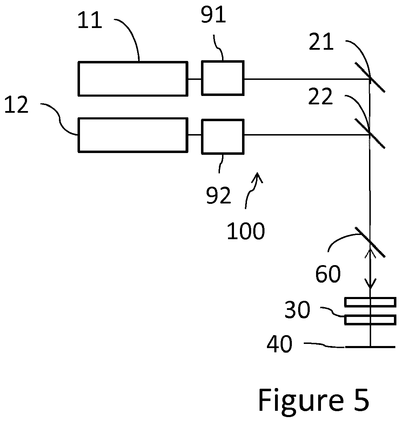

In order to select a single resonance mode of the etalon for feed back into the second laser source a further cut-off filter element 60 may be positioned between the second laser source element 20 and the second long pass filter element 22, as depicted in figure 4 which shows a third exemplary embodiment of the laser beam generating device according to the invention. Or, the further cut-off filter element 60 may be positioned between the second long pass filter element 22 and the etalon 30, as depicted in figure 5 showing a fourth exemplary embodiment of the laser beam generating device according to the invention. The each of the depicted further cut-off filter elements 60 is a long pass filter element having a shortest cut-off wavelength shorter than the first and the second cut-off wavelengths W1, W2.

In the depicted second, third and fourth exemplary embodiments, there is an optical elements 91, 92 for each of the laser diodes 11, 12 located in the external cavity for optimizing performance. But the optical elements 91, 92 are optional and each of these exemplary embodiments of the invention may be realized also with only one or none of the optical elements 91, 92.

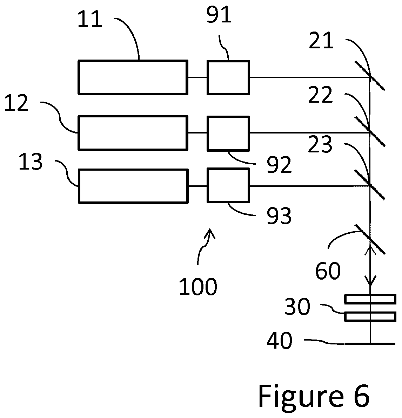

In Figure 6, scaling is exemplarily depicted in a fifth exemplary embodiment of the laser beam generating device according to the invention. That is, for each laser source element to be further combined spectrally there is a cut-off filter element reflecting a part of the respectively irradiated light onto the common path on which the output coupler, the etalon and the cut-off filter elements for spectral combination are positioned. In figure 6 a third laser source element's 13 light is spectrally combined with the light of the first and the second laser source elements 11, 12 via a third long pass filter element 23 having a third cut-off wavelength W3 smaller than the second cut-off wavelength W2.

In Figure 6, the further cut-off filter element 60 is present in the common path, too. In this embodiment the third cut-off wavelength has to be larger than the smallest cut-off wavelength.

In the depicted fifth exemplary embodiment, there is an optical element 91, 92, 93 for each of the laser diodes 11, 12, 13 located in the external cavity for optimizing performance. But the optical elements 91, 92, 93 are optional and this exemplary embodiments of the invention may also be realized with two, only one or none of the optical elements 91, 92, 93.

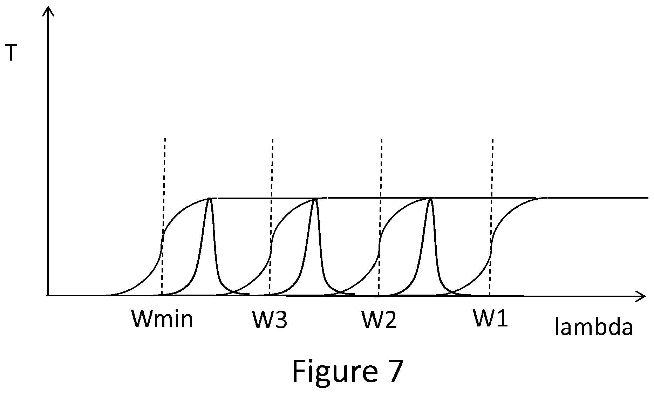

Figure 7 schematically shows transmission T in dependency on wavelength lambda of the cut-off filter elements and the periodic filter element of the exemplary embodiment of figure 6. As exemplarily depicted in figure 7, between each pair of cut-of wavelengths of adjacent cut-off filter elements there is a peak of the periodic filter element.

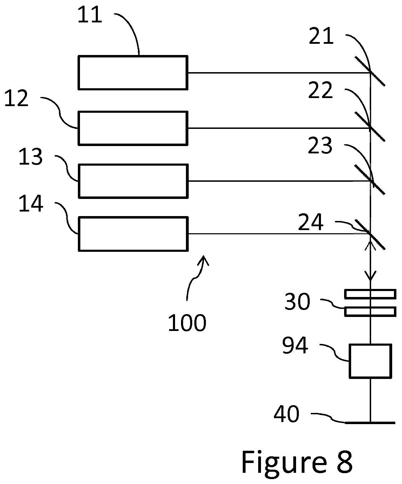

Figure 8 shows a sixth exemplary embodiment of the laser beam generating device according to the invention. In figure 8 light irradiated by four different laser source elements 11, 12, 13, 14 is combined spectrally by means of the cut-off filter elements 21, 22, 23, 24. No further cut-off filter element is present in this example, but it may be added either between the fourth cut-off filter element 24 and either the fourth laser source element 24 or between the fourth cut-off filter element 24 and the etalon 30.

In the depicted sixth exemplary embodiment, there is an optical element 94 located in the external cavity between the etalon 30 and the output coupler 40 for optimizing performance. But the optical element 94 is optional. It may also be arranged between the etalon 30 and the fourth cut-off filter element 24.

Thus, the current invention provides means for spectral combination and frequency locking of n laser light sources through use of n cut-off filters and a single periodic filter. Advantageously a further cut-off filter can be used.

The exemplary embodiments described and depicted make use of long pass filter elements. In an analogous fashion short pass filter elements may be used. Further for each of the cut-off filter elements comprised or used according to the invention it can be decided individually whether it may be embodied by a long pass filter element or by a short pass filter element.

## Claims

1. Laser beam generating device (100) comprising at least one laser source element (11, 12) and an external cavity, the external cavity comprising an output coupler (40) and a periodic filter element (30) arranged, on a light path from the laser source element (11, 12) and the output coupler (40), between the laser source element (11, 12) and the output coupler (40), wherein the laser beam generating device (100) further comprises at least two cut-off filter elements (21, 22) each arranged on the light path between the laser source element (11, 12) and the periodic filter element (30), wherein a first cut-off filter element (21) comprises a first cut-off wavelength (W1) and a second cut-off filter element (22) comprises a second cut-off wavelength (W2), and wherein the at least two cut-off filter elements (21, 22) realize a band pass filter element having a pass band between the at least first and second cut-off wavelengths (W1, W2), wherein the band pass filter selects one or more periodic peaks from the periodic filter element (30) and wherein the periodic filter element (30) is realized by an etalon.

2. Laser beam generating device of claim 1, wherein the cut-off filter elements are long pass-filter elements having different cut-off wavelengths of which each allows radiation of wavelengths longer than a respective cut-off wavelength to pass, and at least reflect radiation of wavelengths shorter than the respective cut-off wavelength

3. Laser beam generating device of claim 2, the at least two long pass filter elements being cold mirrors.

4. Laser beam generating device of claim 3, the cold mirrors comprising dielectric coating layers.

5. Laser beam generating device of one of the preceding claims, wherein the laser source element and the at least two cut-off filter elements being arranged on the light path such that light of the laser source element is irradiated onto a first of the at least two cut-off filter elements and reflected by the first cut-off filter element onto a second of the at least two cut-off filter elements through which it is transmitted.

6. Laser beam generating device of claim 5 further comprising a further laser source element which is arranged on the light path such that further light of the further laser source element is irradiated onto the second cut-off filter element and reflected by the second cut-off filter element such that it is kept in the cavity.

7. Laser beam generating device of claim 6 further comprising a further cut-off filter element arranged, either, on a further light path between the second cut-off filter element and the further laser source element, or, on the light path between the second cut-off filter element and the periodic filter element.

8. Laser beam generating device of claim 6 or 7, the laser source element and the further laser source element being laser diodes emitting light which diverges in a first direction faster than in a second direction perpendicular to the first direction, the laser diodes and dichroic mirrors being arranged such that light of the laser diodes is superposed in the first direction.

9. Laser beam generating device of claim 8, further comprising collimating devices for collimating the light emitted by the laser diodes, the collimating devices collimating in the first direction and in the second direction.

10. Laser beam generating device of claim 8 or 9 the laser diodes being single emitter.

11. Laser beam generating device of one of the preceding claims, the periodic filter element comprising two parallel plates placed spaced apart with air in between wherein sides of the plates facing each other have a reflectivity of 50%.

12. Method for adjusting a wavelength of a laser beam using the laser beam generating device of one of the preceding claims, the method comprising adjusting the wavelength by turning the etalon around an axis.

## Patentansprüche

1. Laserstrahlerzeugungsvorrichtung (100), aufweisend zumindest ein Laserquellenelement (11, 12) und einen externen Resonator, wobei der externe Resonator einen Ausgangskoppler (40) und ein periodisches Filterelement (30), das auf einem Lichtpfad vom Laserquellenelement (11, 12) und vom Ausgangskoppler (40) zwischen dem Laserquellenelement (11, 12) und dem Ausgangskoppler (40) angeordnet ist, aufweist,
wobei
die Laserstrahlerzeugungsvorrichtung (100) ferner zumindest zwei Sperrfilterelemente (21, 22), die jeweils auf dem Lichtpfad zwischen dem Laserquellenelement (11, 12) und dem periodischen Filterelement (30) angeordnet sind, aufweist, wobei ein erstes Sperrfilterelement (21) eine erste Sperrwellenlänge (W1) aufweist und ein zweites Sperrfilterelement (22) eine zweite Sperrwellenlänge (W2) aufweist, und wobei die zumindest zwei Sperrfilterelemente (21, 22) ein Bandpassfilterelement, das ein Durchlassband zwischen der zumindest ersten und zweiten Sperrwellenlänge (W1, W2) aufweist, realisieren, wobei der Bandpassfilter einen oder mehrere periodische Peaks vom periodischen Filterelement (30) auswählt und wobei das periodische Filterelement (30) durch ein Etalon realisiert wird.

2. Laserstrahlerzeugungsvorrichtung nach Anspruch 1, wobei die Sperrfilterelemente Langpassfilterelemente sind, die verschiedene Sperrwellenlängen, von denen jede das Passieren von Strahlung von Wellenlängen, die länger als eine jeweilige Sperrwellenlänge sind, ermöglicht, aufweisen und zumindest Strahlung von Wellenlängen, die kürzer als die jeweilige Sperrwellenlänge sind, reflektieren.

3. Laserstrahlerzeugungsvorrichtung nach Anspruch 2, wobei die zumindest zwei Langpassfilterelemente Kaltlichtspiegel sind.

4. Laserstrahlerzeugungsvorrichtung nach Anspruch 3, wobei die Kaltlichtspiegel dielektrische Beschichtungsschichten aufweisen.

5. Laserstrahlerzeugungsvorrichtung nach einem der vorhergehenden Ansprüche, wobei das Laserquellenelement und die zumindest zwei Sperrfilterelemente derart auf dem Lichtpfad angeordnet sind, dass Licht des Laserquellenelements auf ein erstes der zumindest zwei Sperrfilterelemente gestrahlt wird und vom ersten Sperrfilterelement auf ein zweites der zumindest zwei Sperrfilterelemente, durch das es übertragen wird, reflektiert wird.

6. Laserstrahlerzeugungsvorrichtung nach Anspruch 5, ferner aufweisend ein weiteres Laserquellenelement, das derart auf dem Lichtpfad angeordnet ist, dass weiteres Licht des weiteren Laserquellenelements auf das zweite Sperrfilterelement gestrahlt wird und vom zweiten Sperrfilterelement derart reflektiert wird, dass es im Resonator behalten wird.

7. Laserstrahlerzeugungsvorrichtung nach Anspruch 6, ferner aufweisend ein weiteres Sperrfilterelement, das entweder auf einem weiteren Lichtpfad zwischen dem zweiten Sperrfilterelement und dem weiteren Laserquellenelement oder auf dem Lichtpfad zwischen dem zweiten Sperrfilterelement und dem periodischen Filterelement angeordnet ist.

8. Laserstrahlerzeugungsvorrichtung nach Anspruch 6 oder 7, wobei das Laserquellenelement und das weitere Laserquellenelement Laserdioden sind, die Licht, das in eine erste Richtung schneller als in eine zur ersten Richtung perpendikuläre zweite Richtung divergiert, emittieren, wobei die Laserdioden und dichroitische Spiegel derart angeordnet sind, dass Licht der Laserdioden in der ersten Richtung überlagert wird.

9. Laserstrahlerzeugungsvorrichtung nach Anspruch 8, ferner aufweisend Kollimationsvorrichtungen zum Kollimieren des Lichts, das von den Laserdioden emittiert wird, wobei die Kollimationsvorrichtungen in die erste Richtung und in die zweite Richtung kollimieren.

10. Laserstrahlerzeugungsvorrichtung nach Anspruch 8 oder 9, wobei die Laserdioden einzelne Emitter sind.

11. Laserstrahlerzeugungsvorrichtung nach einem der vorhergehenden Ansprüche, wobei das periodische Filterelement zwei parallele Platten, die mit Luft dazwischen voneinander beabstandet sind, aufweist, wobei Seiten der Platten, die einander zugewandt sind, einen Reflexionsgrad von 50% aufweisen.

12. Verfahren zur Einstellung einer Wellenlänge eines Laserstrahls mittels der Laserstrahlerzeugungsvorrichtung nach einem der vorhergehenden Ansprüche, wobei das Verfahren die Einstellung der Wellenlänge durch Drehen des Etalons um eine Achse aufweist.

## Revendications

1. Dispositif de génération de faisceau laser (100), comprenant au moins un élément de source laser (11, 12) et une cavité externe, la cavité externe comprenant un coupleur de sortie (40) et un élément de filtre périodique (30) disposé, sur un trajet de lumière depuis l'élément de source laser (11, 12) et le coupleur de sortie (40), entre l'élément de source laser (11, 12) et le coupleur de sortie (40),
le dispositif de génération de faisceau laser (100) comprenant en outre au moins deux éléments de filtre de coupure (21, 22) dont chacun est disposé sur le trajet de lumière entre l'élément de source laser (11, 12) et l'élément de filtre périodique (30), un premier élément de filtre de coupure (21) comprenant une première longueur d'onde de coupure (W1), et un second élément de filtre de coupure (22) comprenant une seconde longueur d'onde de coupure (W2), et les au moins deux éléments de filtre de coupure (21, 22) réalisant un élément de filtre passe-bande ayant une bande passante entre les au moins première et seconde longueurs d'onde de coupure (W1, W2), le filtre de passe-bande sélectionnant un ou plusieurs pic/s périodique/s de l'élément de filtre périodique (30), et l'élément de filtre périodique (30) étant réalisé par un étalon.

2. Dispositif de génération de faisceau laser selon la revendication 1, dans lequel les éléments de filtre de coupure sont des éléments de filtre passe-long ayant des longueurs d'onde de coupure différentes dont chacune permet à un rayonnement de longueurs d'onde plus longues qu'une longueur d'onde de coupure respective de passer, et au moins réfléchissent le rayonnement de longueurs d'ondes plus courtes que la longueur d'onde de coupure respective.

3. Dispositif de génération de faisceau laser selon la revendication 2, les au moins deux éléments de filtre passe-long étant des miroirs froids.

4. Dispositif de génération de faisceau laser selon la revendication 3, les miroirs froids comprenant des couches de revêtement diélectrique.

5. Dispositif de génération de faisceau laser selon l'une des revendications précédentes, dans lequel l'élément de source laser et les au moins deux éléments de filtre de coupure sont disposés sur le trajet de lumière de telle manière que la lumière de l'élément de source laser soit irradiée sur un premier élément des au moins deux éléments de filtre de coupure et réfléchie par le premier élément de filtre de coupure sur un second élément des au moins deux éléments de filtre de coupure par lequel elle est transmise.

6. Dispositif de génération de faisceau laser selon la revendication 5, comprenant en outre un autre élément de source laser qui est disposé sur le trajet de lumière de telle manière qu'une autre lumière de l'autre élément de source laser soit irradiée sur le second élément de filtre de coupure et réfléchie par le second élément de filtre de coupure de telle manière qu'elle soit retenue dans la cavité.

7. Dispositif de génération de faisceau laser selon la revendication 6, comprenant en outre un autre élément de filtre de coupure disposé soit sur un autre trajet de lumière entre le second élément de filtre de coupure et l'autre élément de source laser soit sur le trajet de lumière entre le second élément de filtre de coupure et l'élément de filtre périodique.

8. Dispositif de génération de faisceau laser selon les revendications 6 ou 7, l'élément de source laser et l'autre élément de source laser étant des diodes laser émettant de la lumière qui diverge dans une première direction plus rapidement que dans une deuxième direction perpendiculaire à la première direction, les diodes laser et des miroirs dichroïques étant disposés de telle manière que de la lumière des diodes laser soit superposée dans la première direction.

9. Dispositif de génération de faisceau laser selon la revendication 8, comprenant en outre des dispositifs de collimation destinés à collimater la lumière émise par les diodes laser, les dispositifs de collimation effectuant la collimation dans la première direction et dans la deuxième direction.

10. Dispositif de génération de faisceau laser selon les revendications 8 ou 9, les diodes laser étant des émetteurs uniques.

11. Dispositif de génération de faisceau laser selon l'une des revendications précédentes, l'élément de filtre périodique comprenant deux plaques parallèles espacées l'une de l'autre, de l'air se trouvant entre elles, des côtés des plaques qui se font face présentant une réflectivité de 50%.

12. Procédé de réglage d'une longueur d'onde utilisant le dispositif de génération de faisceau laser selon l'une des revendications précédentes, le procédé comprenant le réglage de la longueur d'onde en tournant l'étalon autour d'un axe.
